(19) **Europäisches Patentamt**
**European Patent Office**
**Office européen des brevets**

(11) **EP 4 637 311 A1**

(12) **EUROPEAN PATENT APPLICATION**

(43) Date of publication:
**22.10.2025 Bulletin 2025/43**

(21) Application number: **25170988.7**

(22) Date of filing: **16.04.2025**

(51) International Patent Classification (IPC):
**H10K 59/80** (2023.01)

(52) Cooperative Patent Classification (CPC):
**H10K 59/873; H10K 59/8791**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **18.04.2024 KR 20240052006**

(71) Applicant: **Samsung Display Co., Ltd.
Gyeonggi-do (KR)**

(72) Inventors:
• **Kim, Taeho
Yongin-si, Gyeonggi-Do (KR)**

• **Kwon, Ohjeong
Yongin-si, Gyeonggi-Do (KR)**
• **Kim, Daewon
Yongin-si, Gyeonggi-Do (KR)**
• **Son, Jongho
Yongin-si, Gyeonggi-Do (KR)**
• **Lee, Mihwa
Yongin-si, Gyeonggi-Do (KR)**
• **Jang, Sunggyu
Yongin-si, Gyeonggi-Do (KR)**

(74) Representative: **Gulde & Partner
Patent- und Rechtsanwaltskanzlei mbB
Berliner Freiheit 2
10785 Berlin (DE)**

(54) **DISPLAY PANEL, AND DISPLAY DEVICE INCLUDING THE SAME**

(57)     Provided is a display device (DD). The display device (DD) include a display panel (DP) and a window disposed on the display panel (DP), wherein the display panel (DP) includes: a circuit element layer (D-CL); a display element layer (D-OL) disposed on the circuit element layer (D-CL) and comprising a light emitting element; an encapsulation layer (TFE) disposed on the display element layer (D-OL); a first retarder (RT) disposed on the encapsulation layer (TFE); a first inorganic layer (CP1) disposed on the first retarder (RT); and a second inorganic layer (CP2) disposed on the first inor- ganic layer (CP1), wherein a ratio of oxygen atoms contained in the first inorganic layer (CP1) is less than that of oxygen atoms contained in the second inorganic layer (CP2).

FIG. 5

# EP 4 637 311 A1

**Description**

CROSS-REFERENCE TO RELATED APPLICATION(S)

BACKGROUND

The disclosure herein relates to a display panel and a display device including the same, and more particularly, to a display panel having more improved transmittance and reflectance, and a display device including the same to improve emission characteristics.

Various display devices used in multimedia devices such as televisions, mobile phones, table computers, navigation systems, game consoles, wearable devices are being developed. Such a display device may include a display panel that displays an image. The display panel may use a so-called self-luminous display element that realizes display by emitting a luminescent material including organic compounds or quantum dots in an emission layer disposed between electrodes facing each other.

As the demand for high-definition and portability of multi-media electronic devices increases, there is a demand for display device that are capable of displaying high-resolution display quality while being miniaturized.

SUMMARY

The invention is defined by the appended claims. The description that follows is subjected to this limitation. Any disclosure lying outside the scope of said claims is only intended for illustrative as well as comparative purposes.

The disclosure provides a display panel having improved reliability.

The disclosure also provides a high-resolution display device having excellent display quality.

However, embodiments are not limited to those set forth herein. The above and other embodiments will become more apparent to one of ordinary skill in the art to which the disclosure pertains by referencing the detailed description of the disclosure given below.

An embodiment provides a display device including a display panel and a window disposed on the display panel, wherein the display panel includes: a circuit element layer; a display element layer disposed on the circuit element layer and including a light emitting element; an encapsulation layer disposed on the display element layer; a first retarder disposed on the encapsulation layer; a first inorganic layer disposed on the first retarder; and a second inorganic layer disposed on the first inorganic layer, wherein a ratio of oxygen atoms contained in the first inorganic layer is less than that of oxygen atoms contained in the second inorganic layer.

In other words, the present disclosure introduces a double capping layer on top of an in-cell retarder. Compressive stress and tensile stresses of the in-cell retarder can be reduced, thereby increasing the transmittance and reducing the reflectance of the display device. Compressive stress occurs when the material experiences forces that push it together, leading to internal pressure within the retarder. Tensile stress occurs when the material is stretched, causing internal strain that can affect its optical properties. In an in-cell retarder, which is a birefringent layer integrated into the display structure, these stresses can arise due to thermal expansion mismatches, deposition processes, or material properties.

High internal stresses can distort the molecular alignment of the retarder, reducing its ability to properly control light polarization. By minimizing stress, the retarder functions more efficiently, allowing more light from an emission layer to pass through, improving brightness and efficiency. Internal stresses can cause microstructural defects or unwanted birefringence, which increases light scattering and internal reflections. By reducing stress, the retarder minimizes unwanted reflections, leading to higher image clarity and contrast.

The ratio of oxygen atoms may refer to a ratio of a number of oxygen atoms to a number of all atoms.

In an embodiment, the first inorganic layer may not include oxygen atoms, and thus, the ratio of oxygen atoms the first inorganic layer may be substantially 0.

In an embodiment, a refractive index of the first inorganic layer may be greater than that of the second inorganic layer.

In an embodiment, the refractive index of the first inorganic layer may be greater than about 1.7 and less than or equal to about 2.0 with respect to light having a wavelength of about 550 nm. In an embodiment, the refractive index of the first inorganic layer may be about 1.80 or more and about 1.90 or less with respect to light having a wavelength of about 550 nm.

In an embodiment, the refractive index of the second inorganic layer may be about 1.5 or more and about 1.7 or less with respect to light having a wavelength of about 550 nm. For example, the refractive index of the second inorganic layer may be about 1.55 or more and about 1.65 or less with respect to light having a wavelength of about 550 nm.

In an embodiment, the refractive index of the first inorganic layer may be more than 0% greater, at least 9% greater, at least 23% greater, or at least 33% greater than that of the second inorganic layer.

In an embodiment, the first inorganic layer may include silicon nitride, and/or the second inorganic layer may include silicon nitrogen oxide.

In an embodiment, the first inorganic layer may be indirectly disposed on the first retarder, and/or the second inorganic layer may be indirectly disposed on the first inorganic layer.

In an embodiment, the first inorganic layer may be directly disposed on the first retarder, and/or the second inorganic layer may be directly disposed on the first inorganic layer.

In an embodiment, residual stress of the first inorganic layer may be greater than that of the second inorganic layer.

Residual stress may refer to internal stress (e. g. compressive stress and tensile stresses) that remains within a material after it has undergone manufacturing or processing, even when no external forces are applied. In the case of a first inorganic layer and the second inorganic layer, residual stress may arise due to factors such as thermal expansion mismatches, phase transformations, deposition methods, and substrate interactions. The residual stress of each individual inorganic layer may be determined using an extended Stoney equation by measuring the curvature of the substrate. The stress in each layer depends on its elastic modulus, Poisson's ratio, layer thickness, and the overall curvature of the system. The stress of the first layer may be calculated by measuring the curvature after its deposition. After depositing the second layer, the total curvature is measured again to determine the additional stress. If the second layer is applied to an already stressed first layer, the interactions between the layers may be considered in the stress calculation. To measure the residual stress in each inorganic layer, several methods may be used depending on the material properties, thickness, and required accuracy. One of the techniques is the curvature method based on the Stoney equation. This method measures the bending of a substrate before and after the deposition of a thin film. Optical profilometry or laser scanning may be used to determine the radius of curvature, and the residual stress is then calculated from the curvature changes. Another suitable method is X-ray diffraction (XRD) with the $Sin^2\Psi$ method, which utilizes Bragg's Law to measure strain in the crystal lattice of the thin film. By analyzing the diffraction peak shifts, the in-plane residual stress can be determined. For very thin layers, Raman spectroscopy may be an effective method that detects stress-induced shifts in the vibrational modes of the material. Nanoindentation may also be applied to measure the mechanical properties of each layer, providing indirect information about stress distribution. Additionally, the wafer bowing technique, which involves measuring the deformation of the substrate, may be useful for multilayer systems where stress interactions between layers need to be analyzed. A liquid crystal layer of the first retarder may be formed through a curing process, and the residual stress of the first inorganic layer applied according to the curing process may be greater than residual stress of the second inorganic layer. For example, compressive stress of the first inorganic layer may be greater than compressive stress of the second inorganic layer. In another example, the absolute value of the compressive stress of the first inorganic layer may be greater than the absolute value of the tensile stress of the second inorganic layer.

In an embodiment, a first thickness of the first retarder may be greater than the sum of a second thickness of the first inorganic layer and a third thickness of the second inorganic layer.

In an embodiment, the first thickness may be in a range of about 0.5 $\mu$m to about 2.5 $\mu$m.

In an embodiment, the second thickness may be in a range of about 0.1 $\mu$m to about 0.8 $\mu$m. In an embodiment, the second thickness may be in a range of about 0.2 $\mu$m or more and about 0.4 $\mu$m or less.

In an embodiment, the third thickness may be in a range of about 0.1 $\mu$m to about 0.5 $\mu$m. In an embodiment, the third thickness may be in a range of about 0.1 $\mu$m or more and about 0.4 $\mu$m or less.

In an embodiment, the first thickness of the first retarder may be at least 50% greater, 100% greater, 200% greater, or up to 1000% greater than the sum of the second thickness of the first inorganic layer and the third thickness of the second inorganic layer.

In an embodiment, the second thickness may be equal to or greater than the third thickness.

In an embodiment, the second thickness of the first inorganic layer may be at least 50% greater, 100% greater, 300% greater, or up to 700% greater than the third thickness of the second inorganic layer.

In an embodiment, the first retarder may include a liquid crystal layer, and the liquid crystal layer may have a curing degree of about 70% or more and about 90% or less. The liquid crystal layer may have a curing degree of about 75% or more and about 85% or less. The liquid crystal layer may have a curing degree of about 80%.

The curing degree of a liquid crystal layer may refer to an extent to which a polymerization or crosslinking process has progressed within the liquid crystal matrix. It is a measure of how fully the reactive components in the liquid crystal layer have undergone chemical bonding, typically through UV curing, thermal curing, or chemical curing processes. The curing degree directly influences the mechanical, optical, and electro-optical properties of the liquid crystal layer. It may be expressed as $D_c = (1 - Ct / C_0) \times 100$, where $D_c$ is the curing degree in percent, $C_0$ is the initial concentration of reactive monomers or functional groups, and $C_t$ is the remaining concentration of unreacted monomers or functional groups at a given time. Several methods may be used to determine the curing degree. Fourier Transform Infrared Spectroscopy (FTIR) measures the reduction in the absorption peaks of reactive functional groups, such as C=C double bonds in acrylates, by comparing peak intensities before and after curing. Differential Scanning Calorimetry (DSC) detects the remaining heat of reaction to determine the fraction of unreacted components, with a higher curing degree resulting in a lower exothermic peak. UV-Vis Spectroscopy monitors changes in optical transmission properties before and after curing, useful for evaluating the effects on liquid crystal alignment and transparency. Mechanical and rheological testing measures changes in elasticity, viscosity, and modulus to assess polymerization progress, where a higher curing degree corresponds to increased stiffness and reduced flow behavior. Dielectric and electro-optical measurements evaluate changes in dielectric constants and switching voltages in liquid crystal displays, as curing affects the alignment and response time of liquid crystals under an applied electric field. The curing degree is important because it influences optical properties such as birefringence, transmittance, and scattering, controls mechanical stability by improving durability, optimizes electro-optical performance by ensuring proper alignment and switching behavior, and prevents residual stress and shrinkage, which could otherwise lead to defects, phase separation, or non-uniform alignment. By adjusting curing conditions such as UV intensity, exposure time, temperature, and material composition, the desired material properties in polymer-stabilized and photo-aligned liquid crystal layers can be achieved.

In an embodiment, the first retarder may have a phase difference of about 100 nm or more and about 500 nm or less in a wavelength of about 550 nm. In other words, the first retarder may be configured to introduce a phase difference of about 100 nm or more and about 500 nm or less when light with a wavelength of 550 nm passes through it.

In an embodiment, the first retarder may include a $\lambda/4$ phase difference retarder. In other words, the first retarder may be a $\lambda/4$ phase difference retarder, also known as a quarter-wave plate. A quarter-wave retarder introduces a phase difference of $\lambda/4$ (one-quarter of the wavelength) between two orthogonal polarization components of light. This means that if incident light has a wavelength $\lambda$, the fast and slow axes of the retarder create a 90-degree phase shift between the components.

The phase difference may refer to an optical path difference introduced between two orthogonal polarization components of light passing, for example through the first retarder. This occurs because the first retarder has different refractive indices along its fast and slow optical axes, causing a phase shift between the two polarization components. The phase difference, also known as retardation, is typically expressed in nanometers or as a fraction of the wavelength of the transmitted light. It may be calculated using the equation $\Delta\Phi = (2\pi/\lambda) * (n_e - n_o) * d$, where $\Delta\Phi$ is the phase difference in radians, $\lambda$ is the wavelength of the incident light, $n_e$ and $n_o$ are the extraordinary and ordinary refractive indices of the first retarder material, and d is the thickness of the first retarder. The phase difference may be measured using various optical techniques. Spectroscopic ellipsometry determines the change in polarization state after light passes through the first retarder. Polarized light microscopy can visualize birefringence effects, providing insights into the retardation value. Interferometric methods analyze the optical path differences directly by observing interference fringes. In practical applications, the phase difference of a first retarder is crucial for controlling polarization states in optical systems, liquid crystal displays, and other birefringent devices. By adjusting material properties, thickness, and operating wavelength, the desired phase difference can be precisely controlled to optimize optical performance.

In an embodiment, a Young's modulus of the first retarder RT may be in a range of about 0.1 GPa to about 3 GPa.

In an embodiment, the encapsulation layer may include a first encapsulation inorganic layer disposed on the display element layer, an encapsulation organic layer disposed on the first encapsulation inorganic layer, and a second encapsulation inorganic layer disposed on the encapsulation organic layer.

In an embodiment, the first retarder may be directly disposed on the second encapsulation inorganic layer.

In an embodiment, the display device may further include an optical layer (e. g. a light control panel or a part thereof) disposed between the display panel and the window, wherein the optical layer may include: a second retarder disposed on the second inorganic layer; and a polarizing layer disposed on the second retarder. In an embodiment, the optical layer may include a cover layer disposed below the second retarder.

In an embodiment, the first and/or second retarder may be a film type or a liquid crystal coating type. The film type may include a stretched synthetic resin film, and the liquid crystal coating type may include a base layer and a liquid crystal layer oriented on a surface of the base layer. In an embodiment, the liquid crystal coating type may be provided as only the liquid crystal layer without the base layer as a support. The liquid crystal layer may include a reactive liquid crystal monomer (e.g., calamitic mesogen that exhibits a nematic liquid crystalline phase). In an embodiment, the liquid crystal layer may include a photoreactive polymer having refractive index anisotropy.

In an embodiment, the second retarder may be directly disposed on the second inorganic layer, and/or the polarizing layer may be directly disposed on the second retarder.

In an embodiment, the optical layer may further include a color filter layer disposed between the second inorganic layer and the second retarder. In an embodiment, the cover layer may be disposed on the color filter layer and therefore between the color filter layer and the second retarder.

In an embodiment, the polarizing layer may include a wire grid polarizing plate (in other words a wire grid polarizer). The wire grid polarizing plate may include a substrate and grid lines disposed on the substrate.

In an embodiment, the second retarder may include a $\lambda/4$ phase difference retarder.

In an embodiment, a display panel includes: a circuit element layer; a display element layer disposed on the circuit element layer and including a light emitting element; an encapsulation layer disposed on the display element layer; a first retarder disposed on the encapsulation layer; a first inorganic layer disposed on the first retarder and including silicon nitride; and a second inorganic layer disposed on the first inorganic layer and including silicon nitrogen oxide.

In an embodiment, the display panel may include a base substrate, wherein the circuit element layer is disposed on the base substrate.

In an embodiment, an electronic device may include: a display device including a display panel and a window disposed on the display panel, wherein the display panel may include: a circuit element layer; a display element layer disposed on the circuit element layer and including a light emitting element; an encapsulation layer disposed on the display element layer; a first retarder disposed on the encapsulation layer; a first inorganic layer disposed on the first retarder; and a second inorganic layer disposed on the first inorganic layer, and a ratio of oxygen atoms contained in the first inorganic layer is less than that of oxygen atoms contained in the second inorganic layer.

In other words, the electronic device may include the display device according to an embodiment.

A refractive index of the first inorganic layer may be greater than that of the second inorganic layer.

Residual stress of the first inorganic layer may be greater than that of the second inorganic layer.

A first thickness of the first retarder may be greater than a sum of a second thickness of the first inorganic layer and a third thickness of the second inorganic layer.

The encapsulation layer may include: a first encapsulation inorganic layer disposed on the display element layer, an encapsulation organic layer disposed on the first encapsulation inorganic layer, and a second encapsulation inorganic layer disposed on the encapsulation organic layer.

The electronic device is at least one of a flat panel display, a curved display, a computer monitor, a medical monitor, a television, a billboard, an indoor light, an outdoor light, an indoor signaling light, an outdoor signaling light, a signal light, a head-up display, a fully transparent display, a partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a three-dimensional (3D) display, a virtual reality display, an augmented reality display, a vehicle, a video wall with multiple displays tiled together, a theater screen, a stadium screen, a phototherapy device, or a signboard.

BRIEF DESCRIPTION OF THE FIGURES

The accompanying drawings are included to provide a further understanding of the invention, and are incorporated in and constitute a part of the description. The drawings illustrate embodiments and, together with the description, serve to explain principles of the invention. In the drawings:

FIG. 1A is a schematic perspective view of an electronic device according to an embodiment;
FIG. 1B is an exploded schematic perspective view of the electronic device according to an embodiment;
FIG. 2A is a schematic perspective view of an electronic device according to an embodiment;
FIG. 2B is an exploded schematic perspective view of the electronic device according to an embodiment;
FIG. 3 is a schematic plan view of a display device according to an embodiment;
FIG. 4 is a schematic plan view illustrating a portion of the display device according to an embodiment;
FIG. 5 is a schematic cross-sectional view illustrating a portion of the display device according to an embodiment;
FIG. 6 is a schematic cross-sectional view of a light emitting element according to an embodiment;
FIG. 7 is a schematic cross-sectional view illustrating a portion of a display panel according to an embodiment; and
FIG. 8 is a schematic cross-sectional view illustrating a portion of a display device according to an embodiment.

DETAILED DESCRIPTION

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hardwired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper" "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Hereinafter, a display panel according to an embodiment and a display device according to an embodiment will be described with reference to the drawings.

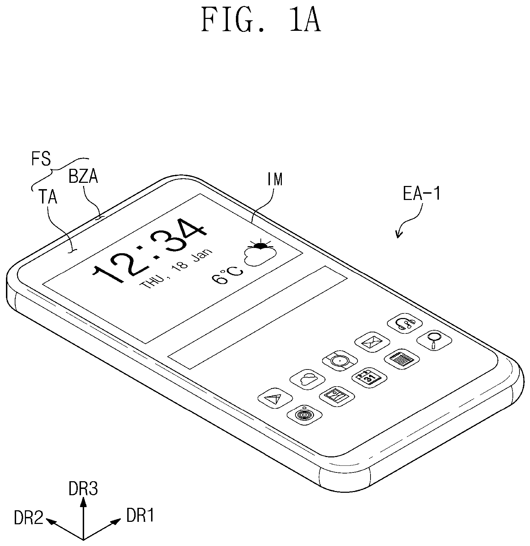

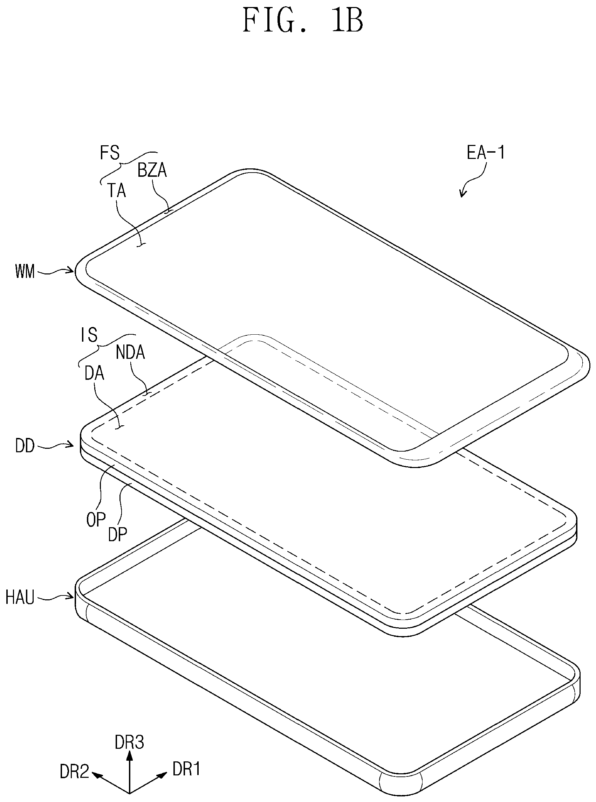

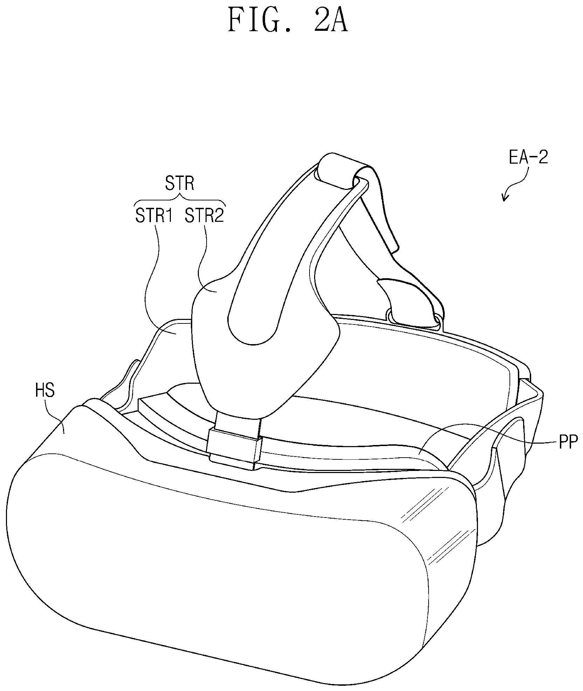

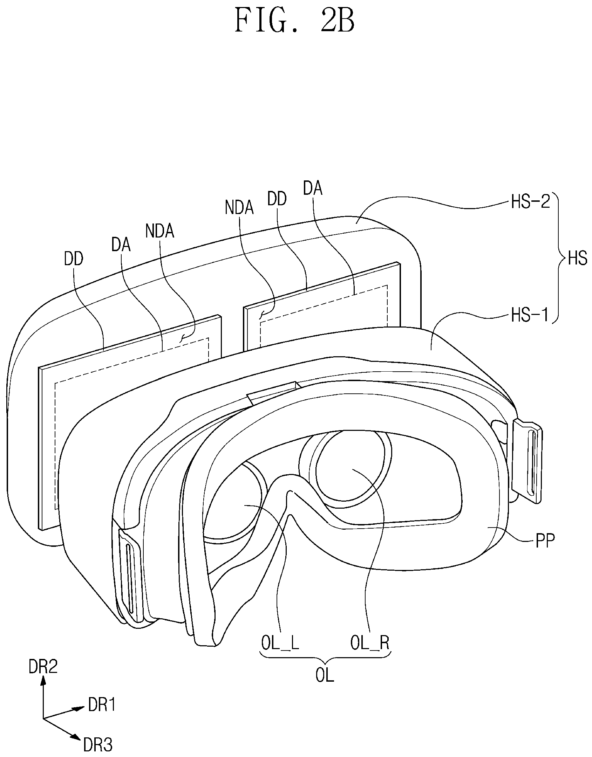

FIG. 1A is a schematic perspective view of an electronic device according to an embodiment. FIG. 1B is an exploded schematic perspective view of the electronic device according to an embodiment. FIG. 2A is a schematic perspective view of an electronic device according to an embodiment, and FIG. 2B is an exploded schematic perspective view of the electronic device according to an embodiment.

Electronic devices EA-1 and EA-2 according to an embodiment may be devices that are activated according to electrical signals to display images. For example, the electronic devices EA-1 and EA-2 may be a flat panel display, a curved display, a computer monitor, a medical monitor, a television, a billboard, an indoor light, an outdoor light, an indoor signaling light, an outdoor signaling light, a signal light, a head-up display, a fully transparent display, a partially transparent display, a flexible display, a rollable display, a foldable display, a stretchable display, a laser printer, a telephone, a mobile phone, a tablet, a phablet, a personal digital assistant (PDA), a wearable device, a laptop computer, a digital camera, a camcorder, a viewfinder, a microdisplay, a three-dimensional (3D) display, a virtual reality display, an augmented reality display, a vehicle, a video wall with multiple displays tiled together, a theater screen, a stadium screen, a phototherapy device, a signboard, etc. However, embodiments of the electronic devices EA-1 and EA-2 are illustrative and are not limited to any one of the embodiments without departing from the disclosure.

FIGS. 1A and 1B illustrate an example in which the electronic device EA-1 according to an embodiment is a smart phone. FIGS. 2A and 2B illustrate an example in which the electronic device EA-2 according to an embodiment is a wearable display device.

Each of the electronic devices EA-1 and EA-2 according to an embodiment may be rigid or flexible. The "flexible" refers to the property of being able to be bent. For example, the flexible electronic devices EA-1 and EA-2 may include curved devices, rollable devices, or foldable devices.

In FIG. 1A and following drawings, first, second, and third directional axes DR1, DR2, and DR3 are illustrated, and directions indicated by the first, second, and third directional axes DR1, DR2, and DR3, which are described in the description, may be converted to other directions as a relative concept. The directions indicated by the first, second, and third directional axes DR1, DR2, and DR3 may be defined as first, second, and third directions DR1, DR2, and DR3, and the same reference numerals may be used. In the description, the first directional axis DR1 and the second directional axis DR2 may be perpendicular to each other. The third directional axis DR3 may be a normal direction with respect to a plane defined by the first direction DR1 and the second direction DR2.

In the electronic device EA-1 according to an embodiment, which is illustrated in FIGS. 1A and 1B, a thickness direction may be a direction parallel to the third directional axis DR3 that is the normal direction with respect to the plane defined by the first directional axis DR1 and the second direction axis DR2. In the description, a front (or top) surface and a rear (or bottom) surface of members constituting the electronic device EA-1 may be defined based on the third direction axis DR3. The front (or top) and rear (or bottom) surfaces of each member constituting the electronic device EA-1 may be opposed to each other in the third direction DR3, and the normal direction of each of the front and rear surfaces may be substantially parallel to the third direction DR3. A spaced distance between the front and rear surfaces defined along the third direction DR3 may correspond to a thickness of the member.

In the description, "in a plan view" may be defined in a state when viewed in the third direction DR3. In the description, "in a cross-section" may be defined in a state when viewed in the first direction DR1 or the second direction DR2. The directions indicated as the first, second, and third directions DR1, DR2, and DR3 may be a relative concept and thus changed into different directions.

Referring to FIGS. 1A and 1B, the electronic device EA-1 according to an embodiment may display an image IM through a display surface FS. The image IM may include a still image as well as a dynamic image. In FIG. 1, a watch and icons are illustrated as an example of the image IM. The display surface FS on which the image IM is displayed may correspond to the front surface of the electronic device EA-1.

Referring to FIG. 1B, the electronic device EA-1 according to an embodiment may include a window module WM, a display device DD, and a housing HAU. The window module WM and the housing HAU may be coupled to each other to define an outer appearance of the electronic device EA-1.

The window module WM may be disposed on the display device DD to protect the display device DD from an external impact or scratches. The window module WM may cover the entire outside of the display device DD. A front surface of the window module WM may define the display surface FS of the electronic device EA-1. The display surface FS may include a transmission area TA and a bezel area BZA. The transmission area TA may be an optically transparent area. For example, the transmission area TA may be an area having visible light transmittance of about 90% more.

The bezel area BZA of the window module WM may be an area having light transmittance that is relatively less than that of the transmission area TA. The bezel area BZA may define a shape of the transmission area TA. The bezel area BZA may be disposed adjacent to the transmission area TA to surround the transmission area TA. However, this is merely an example. For example, in another embodiment, the bezel area BZA may be omitted.

In an embodiment, the window module WM may include a base material that is an optically transparent insulating material. The base material may include at least one of a glass material or a synthetic resin film. The base material may have a single-layer structure or a multi-layer structure in which films are coupled to each other. The window module WM may include a reflection reduction layer disposed on the base material. For example, the reflection reduction layer may include a polarizing layer. For example, the window module WM may further include a functional layer such as an anti-fingerprint layer, a phase control layer, or a hard coating layer.

The window module WM may further include an adhesive layer. The base material and the display device DD may be coupled to each other through the adhesive layer. However, embodiments are not limited thereto. For example, the adhesive layer may be omitted, and the window module WM may be disposed (e.g., directly disposed) on the display device DD.

The display device DD may be disposed below the window module WM. The display device DD may generate the image IM. The image IM generated by the display device DD may be displayed on the display surface IS of the display device DD and be visible to the user from the outside through the transmission area TA.

The display device DD may include a display area DA and a non-display area NDA. The display area DA may be an area that is activated according to an electrical signal. The non-display area NDA is adjacent to the display area DA. The non-display area NDA may surround the display area DA. The non-display area NDA may be an area covered by the bezel area BZA and may not be visible from the outside.

The housing HAU may be coupled to the window module WM. The housing HAU may be coupled to the window module WM to provide an internal space. The display device DD may be accommodated in the internal space of the housing HAU.

The housing HAU may include a material having relatively high rigidity. For example, the housing HAU may include glass, plastic, or a metal or may include frames and/or plates made of a combination of glass, plastic, and a metal. The housing HAU may stably protect the components of the electronic device EA-1 accommodated in the internal space from the external impact.

Referring to FIG. 1B, the display device DD according to an embodiment may include a display panel DP and a light control panel (or optical control panel) OP. For example, the electronic device EA-1 according to an embodiment may further include a protective member disposed on a bottom surface of the display panel DP or an input sensor disposed on the display panel DP. For example, the input sensor may sense the external input using a capacitive method or may sense the external input using an electromagnetic induction method or a pressure sensing method.

The electronic device EA-2 according to an embodiment, which illustrated in FIGS. 2A and 2B, may be a device that is activated according to an electrical signal and may be a wearable device. The wearable device may be a device worn on the user's body and may include a head mounted display (HMD) that implements extended reality (XR). FIGS. 2A and 2B illustrate an example in which the electronic device EA-2 is the head mounted display, but embodiments are not limited thereto.

The electronic device EA-2 according to an embodiment, which is illustrated in FIGS. 2A and 2B, may be a display device worn on the user's head. The electronic device EA-2 may provide images in a state of blocking a user's actual peripheral vision. A user that wears the electronic device EA-2 may be more readily immersed in virtual reality.

The electronic device EA-2 may include a body part HS, a strap part STR, a cushion part PP, and a display device DD. For example, the electronic device EA-2 may include various sensors and a camera.

The body part HS may be worn on the user's head. A display panel DP that displays an image and an acceleration sensor may be accommodated inside the body part HS. The acceleration sensor may sense user's movement to transmit a selected signal to the display device DD. Thus, the display device DD may provide an image corresponding to a change in the user's gaze. Thus, the user may experience virtual reality similar to actual reality. The display device DD may include the display panel DP (see FIG. 1B) and the light control panel OP (see FIG. 1B), as described with reference to FIG. 1B. However, embodiments are not limited thereto, and configurations of the display device DD included in the electronic device EA-2 according to an embodiment may be provided to include configurations different from those illustrated in FIG. 1B to suit characteristics of the wearable device.

In the body part HS, components having various functions other than those described above may be accommodated. For example, a manipulation part that adjusts a volume or screen brightness may be additionally disposed outside the body part HS. The manipulation part may be provided as a physical button or may be provided in the form of a touch sensor. For example, a proximity sensor that determines whether the user is wearing the device may be accommodated in the body part HS. For example, an external display panel may be further disposed on the body part HS.

The body part HS may be divided into a body HS-1 and a cover HS-2. FIG. 2B illustrates an example in which the body part HS is divided into the body HS-1 and the cover HS-2, but embodiments are not limited thereto. For example, the body HS-1 and the cover HS-2 may be provided in a single body and thus may not be separated from each other.

The display devices DD may be disposed between the body HS-1 and the cover HS-2. Each of the display devices DD may provide an image through the display area DA. Each of the display devices DD may include a non-display area NDA surrounding the display area DA. In another embodiment, the non-display area NDA may be placed only at one side of the display area DA or may be omitted.

In FIG. 2B, an example in which a left eye image and a right eye image are respectively provided by the display devices DD, which are separated from each other, is illustrated, but embodiments are not limited thereto. For example, the left eye image and the right eye image may be displayed through a single display device. The display devices DD may be driven by separate driving parts, respectively. However, embodiments are not limited thereto, and the display devices DD may be driven by a single driving part. The display devices DD may generate images corresponding to input image data.

The strap part STR may be coupled to the body part HS so that the body part HS may be readily worn by the user. The strap part STR may include a main strap STR1 and an upper strap STR2.

The main strap STR1 may be worn along a circumference of the user's head. The main strap STR1 may fix the body part HS to the user so that the body part HS may be in close contact with the user's head. The upper strap STR2 may connect the body part HS to the main strap STR1 along the top of the user's head. The upper strap STR2 may prevent the body part HS from falling down. For example, the upper strap STR2 may distribute a load on the body part HS to further improve the user's wearing comfort.

If the body part HS is fixed to the user, the strap part STR may be modified into various shapes other than those illustrated in FIG. 2A. For example, in another embodiment, the upper strap STR2 may be omitted. In another embodiment, the strap part STR may be modified into various forms, such as a helmet coupled to the body part HS or a glasses temple coupled to the body part HS.

The cushion part PP may be disposed between the body part HS and the user's head. The cushion part PP may be made of a material of which a shape is freely or variously deformable. For example, the cushion part PP may be made of a polymer resin (e.g., polyurethane, polycarbonate, polypropylene, and polyethylene) or be made of rubber fluid, an urethane-based material, or sponge made by foaming and molding an acrylic material. However, embodiments are not limited thereto.

The cushion part PP may allow the body part HS to be in close contact with the user, thereby improving the user's wearing comfort. The cushion part PP may be detached from the body part HS. In another embodiment, the cushion part PP may be omitted.

An optical system OL may be disposed inside the body HS-1 of the body part HS. The optical system OL may enlarge the images provided from the display devices DD. Each of the display devices DD may display an image in the third direction DR3 through the display area DA that is parallel to the first direction DR1 and the second direction DR2 intersecting the first direction DR1. The optical system OL may be disposed to be spaced apart from the display devices DD in the third direction DR3. The optical system OL may be disposed between the display devices DD and the user's eyes. The optical system OL may include a right eye optical system OL_R and a left eye optical system OL_L. The left eye optical system OL_L may enlarge and provide an image to the user's left pupil, and the right eye optical system OL_R may enlarge and provide an image to the user's right pupil.

The left eye optical system OL_L and the right eye optical system OL_R may be disposed to be spaced apart from each other in the second direction DR2 intersecting the first direction DR1. A distance between the right eye optical system OL_R and the left eye optical system OL_L may be adjusted to correspond to a distance between the user's two eyes. For example, the distance between the optical system OL and the display panels DP may be adjusted according to the user's vision.

The optical system OL may be a convex aspherical lens. For example, the optical system OL may be a pancake lens, but embodiments are not limited thereto. In this embodiment, an example in which each of the left eye optical system OL_L and the right eye optical system OL_R is provided as a single lens is illustrated, but embodiments are not limited thereto. For example, each of the left eye optical system OL_L and the right eye optical system OL_R may include lenses.

The electronic device EA-2 according to an embodiment, which is illustrated in FIGS. 2A and 2B, may further include a window member disposed on the display device DD. The window member may include a base material and a reflection reduction layer.

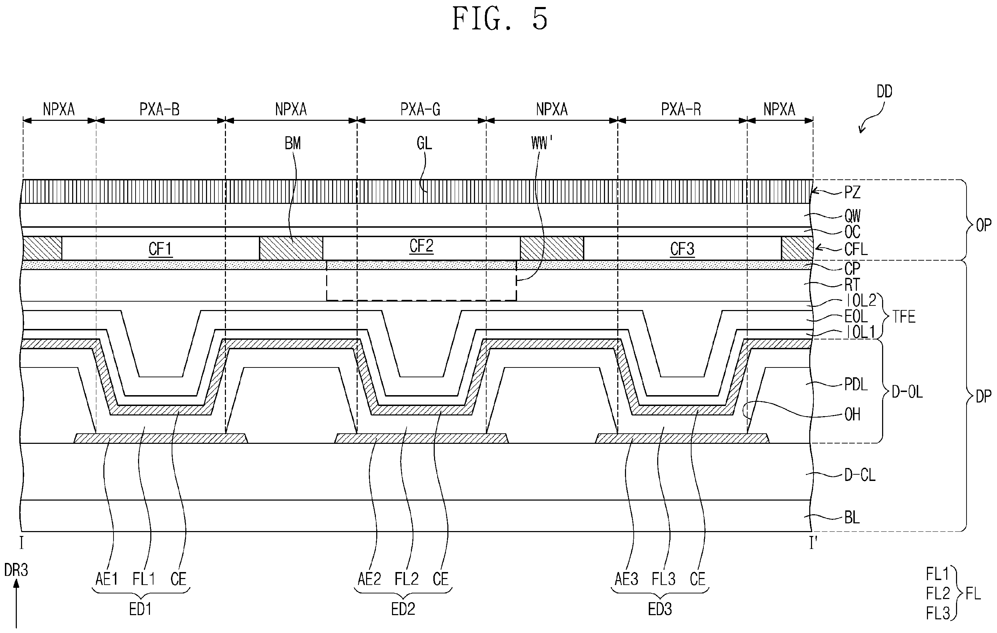

The display device DD included in each of the electronic device EA-1 and EA-2 according to an embodiment described with reference to FIGS. 1A to 2B may include an organic light emitting display panel, an inorganic light emitting display panel, and an organic-inorganic light emitting display panel, a quantum dot display panel, a micro LED display panel, or a nano LED display panel. In this embodiment, an example in which the display devices DD includes the organic light emitting display panel is illustrated, but embodiments are not limited thereto. The display device DD included in each of the electronic devices EA-1 and EA-2 according to an embodiment may have high-resolution characteristics. For example, the display device DD according to an embodiment may have ultra-high resolution display quality having 3000 ppi or higher. Thus, pixel electrodes (or first electrodes) constituting light emitting elements ED1, ED2, and ED3 (see FIG. 5) included in the display device DD according to an embodiment may be provided as a fine pattern having high precision.

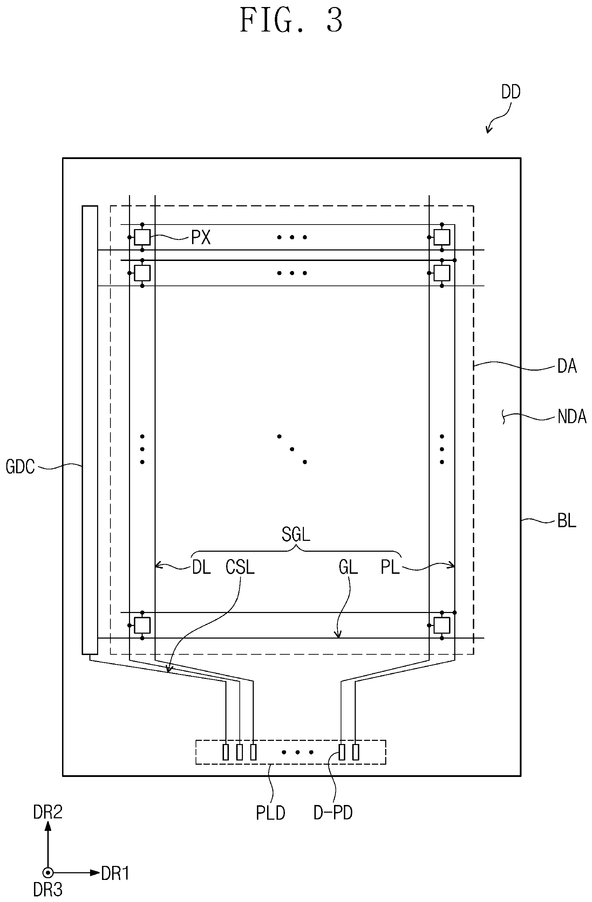

FIG. 3 is a schematic plan view of a display device according to an embodiment. The display device DD may include a base substrate BL divided into a display area DA and a non-display area NDA.

The display device DD may include pixels PX disposed on the display area DA and signal lines SGL electrically connected to the pixels PX. The display device DD may include a driving circuit GDC and a pad part PLD disposed on the non-display area NDA.

The pixels PX may be arranged in the first direction DR1 and the second direction DR2. The pixels PX may include pixel rows extending in the first direction DR1 and arranged in the second direction DR2 and pixel columns extending in the second direction DR2 and arranged in the first direction DR1.

The signal lines SGL may include gate lines GL, data lines DL, power line PL, and control signal line CSL. Each of the gate lines GL may be connected to a corresponding pixel of the pixels PX, and each of the data lines DL may be connected to a corresponding pixel of the pixels PX. The power line PL may be electrically connected to the pixels PX. The control signal line CSL may be connected to the driving circuit GDC to provide a control signal to the driving circuit GDC.

The driving circuit GDC may include a gate driving circuit. The gate driving circuit may generate gate signals and sequentially output the generated gate signals to the gate lines GL. The gate driving circuit may further output another control signal to the pixel driving circuit.

The pad part PLD may be a portion to which a flexible circuit board is connected. The pad part PLD may include pixel pads D-PD, and the pixel pads D-PD may be pads that connect the flexible circuit board to the display panel DP. Each of the pixel pads D-PD may be connected to a corresponding signal line of the signal lines SGL. The pixel pads D-PD may be connected to corresponding pixels PX through the signal lines SGL, respectively. For example, any one of the pixel pads D-PD may be connected to the driving circuit GDC.

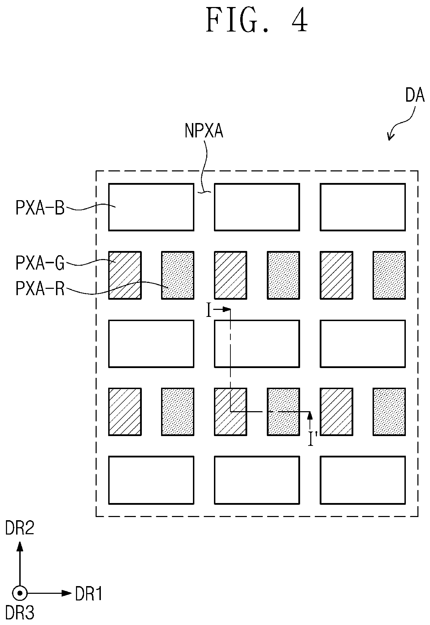

FIG. 4 is a schematic plan view illustrating a portion of the display device according to an embodiment. FIG. 4 illustrates a portion of the display area DA (see FIG. 1B) when viewed on the display surface IS (see FIG. 1B) of the display device DD (see FIG. 1B). FIG. 4 illustrates an arrangement of emission areas PXA-B, PXA-G, and PXA-R in the display device DD (see FIG. 1B) according to an embodiment.

The display panel according to an embodiment may be disposed between emission areas PXA-B, PXA-G, and PXA-R, which are spaced apart from each other in a plan view, and peripheral area NPXA disposed between the emission areas PXA-B, PXA-G, and PXA-R.

The display device according to an embodiment may include three types of emission areas PXA-B, PXA-G, and PXA-R, which are distinguished from each other. In an embodiment, the three types of emission areas PXA-B, PXA-G, and PXA-R illustrated in FIG. 4 may be repeatedly disposed throughout the display area DA. The emission areas PXA-B, PXA-G, and PXA-R may also be called pixel areas.

The display area DA may emit light having different wavelength ranges and may include a first emission area PXA-B, a second emission area PXA-G, and a third emission area PXA-R, which are spaced apart from each other in a plan view. For example, the display area DA may include the peripheral area NPXA. The peripheral area NPXA may be referred to as a non-emission area.

The peripheral area NPXA may be disposed around the first, second, and third emission areas PXA-B, PXA-G, and PXA-R. The peripheral area NPXA may set boundaries between the first, second, and third emission areas PXA-B, PXA-G, and PXA-R. The peripheral area NPXA may surround the first, second, and third emission areas PXA-B, PXA-G, and PXA-R. A structure that prevents color mixing between the first, second, and third emission areas PXA-B, PXA-G, and PXA-R, for example, a pixel defining layer PDL (see FIG. 5) may be accordingly displayed on the peripheral area NPXA.

The first, second, and third emission areas PXA-B, PXA-G, and PXA-R may correspond to areas, on which light provided from the light emitting elements ED1, ED2, and ED3 (see FIG. 5) are emitted, respectively. The first, second, and third emission areas PXA-B, PXA-G, and PXA-R may be distinguished according to colors of light emitted toward the outside of the display device DD (see FIG. 1B).

The first, second, and third emission areas PXA-B, PXA-G, and PXA-R may provide first, second, and third color light, which have different colors. For example, the first color light may be blue light, the second color light may be green light, and the third color light may be red light. However, examples of the first, second, and third color lights are not necessarily limited thereto.

Each of the first, second, and third emission areas PXA-B, PXA-G, and PXA-R may correspond to an area on which a top surface of each of the first electrodes AE1, AE2, and AE3 (see FIG. 5) of the light emitting element is exposed by a light emitting opening OH to be described later. In an embodiment, each of the first, second, and third emission areas PXA-B, PXA-G, and PXA-R may be defined as an area between the pixel defining layers PDL (see FIG. 5) that define the light emitting opening OH (see FIG. 5). For example, in an embodiment, the emission areas PXA-B, PXA-G, and PXA-R may be defined as areas between the pixel defining layers PDL (see FIG. 5) that protrude most toward the light emitting opening OH (see FIG. 5).

Each of the first, second, and third emission areas PXA-B, PXA-G, and PXA-R may be provided in plurality and may be repeatedly disposed in a selected arrangement within the display area DA. For example, the first emission areas PXA-B may be arranged along the first direction DR1 to constitute a 'first group'. The second and third emission areas PXA-G and PXA-R may be alternately arranged along the first direction DR1 to constitute a 'second group'. Each of the 'first group' and 'second group' may be provided in plurality, and the 'first groups' and 'second groups' may be arranged alternately along the second direction DR2.

FIG. 4 illustrates an example of the arrangement of the first, second, and third emission areas PXA-B, PXA-G, and PXA-R, but embodiments are not limited thereto. For example, the emission areas may be arranged in various shapes. In an embodiment, the first, second, and third emission areas PXA-B, PXA-G, and PXA-R may have a PENTILE™ arrangement. In another example, the first, second, and third emission areas PXA-R, PXA-G, and PXA-B may have a stripe arrangement or a diamond (e.g., Diamond Pixel™) arrangement.

The first, second, and third emission areas PXA-B, PXA-G, and PXA-R may have various shapes in a plan view. For example, the first, second, and third emission areas PXA-B, PXA-G, and PXA-R may have a polygonal, circular, or oval shape. In FIG. 4, an example in which the first, second, and third emission areas PXA-B, PXA-G, and PXA-R have a rectangular shape in a plan view is illustrated.

The first, second, and third emission areas PXA-B, PXA-G, and PXA-R may have the same shape in a plan view, or at least a portion of the first, second, and third emission areas PXA-B, PXA-G, and PXA-R may have a different shape. FIG. 4 illustrates a case in which the first, second, and third emission areas PXA-B, PXA-G, and PXA-R have the same shape in a plan view.

At least a portion of the first, second, and third emission areas PXA-B, PXA-G, and PXA-R may have a different surface area in a plan view. In an embodiment, a surface area of the first emission area PXA-B that emits blue light may be greater than that of each of the second emission area PXA-G that emits green light and the third emission area PXA-R that emits red light. However, a size relationship between the surface areas between the first, second, and third emission areas PXA-B, PXA-G, and PXA-R according to the emission color is not limited thereto and may vary according to a design of the display device according to an embodiment. Embodiments are not limited thereto, and the first, second, and third emission areas PXA-B, PXA-G, and PXA-R may have the same surface area in a plan view.

The shape, the surface area, and the arrangement of the first, second, and third emission areas PXA-B, PXA-G, and PXA-R in the display device according to an embodiment may be variously designed according to the color of the emitted light or the size and configuration of the display device included in the electronic device, but embodiments are not limited to the embodiment illustrated in FIG. 4. For example, in an embodiment, the display device may further include an emission area that emits white light in addition to the first, second, and third emission areas PXA-B, PXA-G, and PXA-R.

FIG. 5 is a schematic cross-sectional view illustrating the display device according to an embodiment. FIG. 5 is a schematic cross-sectional view taken along line I-I' of FIG. 4.

The display device DD according to an embodiment may include a display panel DP and a light control panel (e.g., optical control panel) OP disposed on the display panel DP.

The display panel DP may include first, second, and third emission areas PXA-B, PXA-G, and PXA-R, which are distinguished from each other, and a peripheral area NPXA disposed between the first, second, and third emission areas PXA-B, PXA-G, and PXA-R.

The display panel DP may include a base substrate BL, a circuit element layer D-CL disposed on the base substrate BL, a display element layer D-OL disposed on the circuit element layer D-CL, an encapsulation layer TFE disposed on the display element layer D-OL, a first retarder RT disposed on the encapsulation layer TFE, and an inorganic capping layer CP disposed on the first retarder RT.

The display element layer D-OL may be disposed to correspond to the display area DA (see FIGS. 1B and 2B). However, embodiments are not limited thereto, and at least a portion of the display element layer D-OL may be disposed on the non-display area NDA (see FIGS. 1B and 2B).

The base substrate BL may be a support substrate provided with the circuit element layer D-CL and the display element layer D-OL. The base substrate BL may include a plastic substrate, a glass substrate, a metal substrate, or an organic/inorganic composite substrate. In an embodiment, the base substrate BL may be a silicon substrate, a germanium substrate, or a silicon on insulator (SOI) substrate. For example, the base substrate BL may be a single crystal silicon substrate, but embodiments are not limited thereto.

In the description, the display area DA (see FIGS. 1B and 2B) and the non-display area NDA (see FIGS. 1B and 2B) may be viewed as being defined on the base substrate BL. For example, the components disposed on the base substrate BL may be disposed to overlap the display area DA (see FIGS. 1B and 2B) and the non-display area NDA (see FIGS. 1B and 2B).

The circuit element layer D-CL may include at least one insulating layer and a circuit element. The circuit element may include the signal line and the driving circuit of the pixel. The circuit element layer D-CL may be formed through a process of forming an insulating layer, a semiconductor layer, and a conductive layer by coating or deposition and a process of patterning the insulating layer, the semiconductor layer, and the conductive layer by a photolithography process.

The display element layer D-OL may include a pixel defining layer PDL and light emitting elements distinguished from the pixel defining layer PDL. The display element layer D-OL may include a first light emitting element ED1, a second light emitting element ED2, and a third light emitting element ED3. The first light emitting element ED1 may emit blue light, the second light emitting element ED2 may emit green light, and the third light emitting element ED3 may emit red light.

The first light emitting element ED1 may include a first pixel electrode AE1, a first functional layer FL1, and a second electrode CE, the second light emitting element ED2 may include a second pixel electrode AE2, a second functional layer FL2, and a second electrode CE, and the third light emitting element ED3 may include a third pixel electrode AE3, a third functional layer FL3, and a second electrode CE. Each of the first, second, and third pixel electrodes AE1 may be referred to as a first electrode AE.

In an embodiment, the first electrodes AE1, AE2, and AE3 of the first, second, and third light emitting elements ED1, ED2, and ED3 may be disposed to be patterned corresponding to the first, second, and third emission areas PXA-B, PXA-G, and PXA-R, respectively.

In an embodiment, the first, second, and third functional layers FL1, FL2, and FL3 may be provided as common layers to overlap the entire emission areas PXA-R, PXA-G, and PXA-B and the entire peripheral area NPXA. In an embodiment, the second electrode CE may be provided as a common layer to overlap the entire emission areas PXA-R, PXA-G, and PXA-B and the entire peripheral area NPXA. However, embodiments are not limited thereto. At least one of the first, second, and third functional layers FL1, FL2, and FL3 or the second electrode CE may be interrupted and disposed to correspond to each of the emission areas PXA-R, PXA-G, and PXA-B.

The first electrode AE may be an anode or a cathode. For example, the first electrode AE may be a pixel electrode. The second electrode CE may be a cathode or an anode. The second electrode CE may be a common electrode. For example, in case that the first electrode AE is the anode, the second electrode CE may be the cathode, and in case that the first electrode AE is the cathode, the second electrode CE may be the anode.

The functional layer FL may include at least one light emitting structure. The functional layer FL may include at least one organic layer commonly provided on the emission areas PXA-B, PXA-G, and PXA-R (see FIG. 4). For example, the functional layer FL may include a common layer provided in common to the emission areas PXA-B, PXA-G, and PXA-R (see FIG. 4) and an emission layer patterned to correspond to each of the emission areas PXA-B, PXA-G, and PXA-R (see FIG. 4). For example, unlike this structure, the functional layer FL may be interrupted on the peripheral area NPXA (see FIG. 4) and patterned to correspond to each of the emission areas PXA-B, PXA-G, and PXA-R (see FIG. 4). The configuration of the functional layer FL of the light emitting elements ED1, ED2, and ED3 will be described in more detail later.

The light emitting elements ED1, ED2, and ED3 according to an embodiment may further include a capping layer disposed on the second electrode CE. The capping layer may include multiple layers or a single layer.

The display element layer D-OL may include a pixel defining layer PDL disposed on the circuit element layer D-CL. A light emitting opening OH may be defined in the pixel defining layer PDL. A light emitting opening OH of the pixel defining layer PDL may expose at least a portion of the first electrode AE. In an embodiment, the pixel defining layer PDL may cover an edge of the first electrode AE.

The pixel defining layer PDL may have a single-layer structure or a multi-layer structure. The pixel defining layer PDL may be made of an inorganic material. For example, the pixel defining layer PDL may be made of an inorganic material such as silicon nitride ($SiN_x$), silicon oxide ($SiO_x$), or silicon oxynitride ($SiO_xN_y$).

However, embodiments are not limited thereto, and the pixel defining layer PDL may be made of a polymer resin. For example, the pixel defining layer PDL may include a polyacrylate-based resin a polyimide-based resin. For example, the pixel defining layer PDL may further include an inorganic material in addition to the polymer resin. The pixel defining layer PDL may include a light absorbing material or may include a black pigment or a black dye. The pixel defining layer PDL including the black pigment or the black dye may realize a black pixel defining layer. In case of forming a pixel defining layer PDL, carbon black or the like may be used as a black pigment or black dye, but embodiments are not limited thereto.

The encapsulation layer TFE may be disposed on the second electrode CE of the light emitting elements ED1, ED2, and ED3. In another example, in case that the light emitting elements ED1, ED2, and ED3 include the capping layer, the encapsulation layer TFE may be disposed on the capping layer. The encapsulation layer TFE may cover the light emitting elements ED1, ED2, and ED3.

The encapsulation layer TFE may be a thin film encapsulation layer. The encapsulation layer TFE may be provided as a single layer or a laminate in which multiple layers are laminated. The encapsulation layer TFE may include a first encapsulation inorganic layer IOL1, an encapsulation organic layer EOL, and a second encapsulation inorganic layer IOL2, which are sequentially laminated. The first and second encapsulation inorganic layers IOL1 and IOL2 may protect the light emitting elements ED1, ED2, and ED3 from moisture/oxygen, and the encapsulation organic layer EOL may protect the light emitting elements ED1, ED2, and ED3 from foreign substances such as dust particles. Each of the first and second encapsulation inorganic layers IOL1 and IOL2 may include silicon nitride, silicon oxy nitride, silicon oxide, titanium oxide, or aluminum oxide, but embodiments are not limited thereto. The encapsulation organic layer EOL may include an acrylic compound, an epoxy compound, etc. The encapsulation organic layer EOL may include a photopolymerizable organic material, but embodiments are not limited thereto.

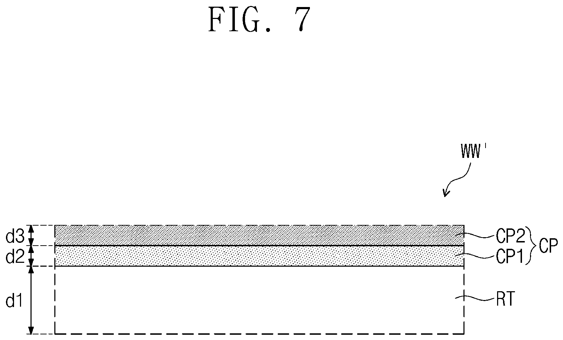

The first retarder RT may be disposed to improve optical efficiency. The first retarder RT may be disposed (e.g., directly disposed) on the encapsulation layer TFE, e. g. on the second encapsulation inorganic layer IOL2. The inorganic capping layer CP may cover the first retarder RT. The inorganic capping layer CP may be disposed (e.g., directly disposed) on the first retarder RT. A detailed description of the first retarder RT and the inorganic capping layer CP will be described later in FIG. 7. The light control panel OP may be disposed on the display panel DP. The light control panel may also be referred to as an optical layer or may correspond to an optical layer. The optical layer may also be a part of the light control panel or may include a part of the light control panel. The light control panel OP may include a color filter layer CFL, a second retarder QW disposed on the color filter layer CFL, and a polarizing layer PZ disposed on the second retarder QW.

The color filter layer CFL may include a division pattern BM and at least one color filter CF1, CF2, or CF3. Each of the color filters CF1, CF2, and CF3 may transmit light having a specific wavelength range and block light having a wavelength range out of a corresponding wavelength range. In an embodiment, the first color filter CF1 may be a blue filter, the second color filter CF2 may be a green filter, and the third color filter CF3 may be a red filter.

Each of the color filters CF1, CF2, and CF3 may include a polymer photosensitive resin and a colorant. The colorant may include a pigment or a dye. The first color filter CF1 may include a blue pigment or blue dye, the second color filter CF2 may include a green pigment or green dye, and the third color filter CF3 may include a red pigment or red dye. In an embodiment, the first color filter CF1 may not include the pigment or the dye.

The first, second, and third color filters CF1, CF2, and CF3 may be disposed to correspond to the first emission area PXA-B, the second emission area PXA-G, and the third emission area PXA-R, respectively.

Each of the color filters CF1, CF2, and CF3 may be disposed to correspond to an opening defined in the division pattern BM. The color filters CF1, CF2, and CF3 may transmit light provided from the overlapping light emitting elements ED1, ED2, and ED3 respectively corresponding to the color filters CF1, CF2, and CF3. Color reproducibility of the light provided from the light emitting elements ED1, ED2, and ED3 may be improved by the color filters CF1, CF2, and CF3. For example, light having a specific wavelength range among the light provided from the light emitting elements ED1, ED2, and ED3 may be transmitted by the color filters CF1, CF2, and CF3.

Unlike that illustrated in FIG. 5, in an embodiment, the color filter layer CFL may not include the division pattern, and the color filters CF1, CF2, and CF3 that transmit different light to correspond to the peripheral area NPXA may be disposed to overlap each other. The color filters CF1, CF2, and CF3 may be disposed to overlap each other in the third direction DR3, which is a thickness direction, so as to correspond to the peripheral area NPXA so that boundaries between the adjacent emission areas PXA-B, PXA-G, and PXA-R may be distinguished from each other.

A material forming the division pattern BM is not particularly limited as long as it is a material that absorbs light. The division pattern BM may be a layer having a black color. In an embodiment, the division pattern BM may include a black coloring agent. The block coloring agent may include a black dye and a black pigment. The black coloring agent may include carbon black, a metal such as chromium, or oxides thereof.

For example, the light control panel OP may further include a lens pattern disposed on an upper portion of each of the color filters CF1, CF2, and CF3. The lens pattern may control a direction of light emitted from the light emitting elements ED1, ED2, and ED3 or improve light extraction efficiency. The lens pattern may have a lens shape and may have a convex shape protruding in a direction away from the display panel DP. The lens pattern may be referred to as a micro lens.

The cover layer OC may be disposed on the color filter layer CFL. The cover layer OC may cover the color filters CF1, CF2, and CF3 and the division pattern BM. The cover layer OC may be made of an organic material including a polymer resin. For example, the cover layer OC may be made of an organic resin including an acrylic resin or an epoxy resin. However, embodiments are not limited thereto.

The second retarder QW may change a polarization state of light incident into the second retarder QW. The second retarder QW may include a $\lambda/4$ phase difference retarder. The second retarder QW may be an optical layer or a part thereof that delays a phase of provided light by $\lambda/4$. The second retarder QW may be a film type or a liquid crystal coating type. The film type may include a stretched synthetic resin film, and the liquid crystal coating type may include a base layer and a liquid crystal layer oriented on a surface of the base layer. However, embodiments are not limited thereto, and the liquid crystal coating type may be provided as only the liquid crystal layer without the base layer as a support. The liquid crystal layer may include a reactive liquid crystal monomer (e.g., calamitic mesogen that exhibits a nematic liquid crystalline phase). In an embodiment, the liquid crystal layer may include a photoreactive polymer having refractive index anisotropy.

The polarizing layer PZ may include a wire grid polarizer. The wire grid polarizer may include a substrate and grid lines GL disposed on the substrate. The grid line GL may be provided as a nanowire made of a metal. The grid lines GL may be disposed with a period shorter than a wavelength of the incident light. A wire grid polarizer may serve to convert light provided from the light emitting elements ED1, ED2, and ED3 into polarized light. Light, of which electric fields are oscillated in a direction parallel to the grid line GL, of the light passing through the wire grid polarizer may be reflected, and light of which electric fields are oscillated in a direction perpendicular to the grid line GL may be transmitted.

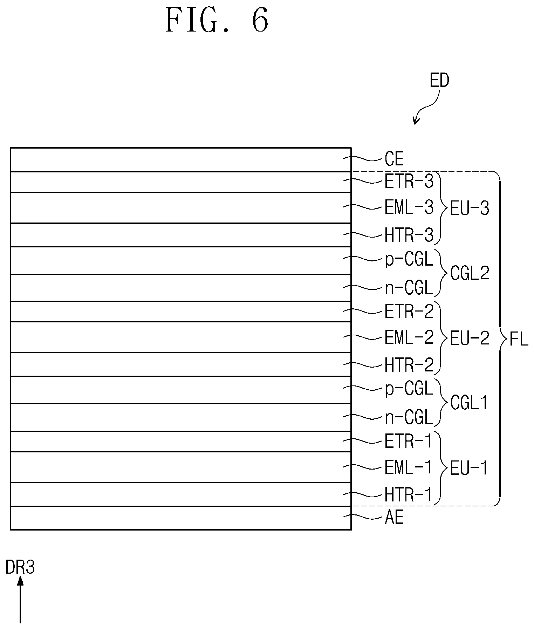

FIG. 6 is a schematic cross-sectional view of a light emitting element according to an embodiment. Each of the first, second, and third light emitting elements ED1, ED2, and ED3, which are illustrated in FIG. 5, may have a configuration according to the embodiment of the light emitting element ED illustrated in FIG. 6.

Referring to FIG. 6, the light emitting element ED according to an embodiment may include a first electrode AE, a functional layer FL, and a second electrode CE, and the functional layer FL may include light emitting structures EU-1, EU-2, and EU-3. The light emitting structures EU-1, EU-2, and EU-3 may include emission layer EML-1, EML-2, and EML-3, respectively. Thus, the functional layer FL may include emission layers EML-1, EML-2, and EML-3. For example, the light emitting element ED according to an embodiment may be a light emitting element having a tandem structure including emission layers EML-1, EML-2, and EML-3, which are divided into each other. FIG. 6 illustrates a structure in which three light emitting structures EU-1, EU-2, and EU-3 are laminated, but embodiments are not limited thereto. For example, the light emitting element ED may include two light emitting structures that are laminated or may include four or more light emitting structures that are laminated. In an embodiment, the number of light emitting structures included in the light emitting element ED may be selected in consideration of a wavelength range of light required by the light emitting element ED.

In an embodiment, the first electrode AE may be made of a metal material, a metal alloy, or a conductive compound. The first electrode AE may be a reflective electrode. The first electrode AE may include Ag, Mg, Cu, Al, Pt, Pd, Au, Ni, Nd, Ir, Cr, Li, Ca, LiF/Ca (e.g., laminated structure of LiF and Ca), LiF/Al (e.g., laminated structure of LiF and Al), Mo, Ti, W, or a compound or mixture thereof (for example, a mixture of Ag and Mg). In another example, the first electrode AE may have a multi-layered structure including a reflective layer or transflective layer and a transparent conductive layer made of indium tin oxide (ITO), indium zinc oxide (IZO), zinc oxide (ZnO), or indium tin zinc oxide (ITZO). The first electrode AE of the light emitting element according to an embodiment, which has the multi-layered structure, will be described in more detail later.

The second electrode CE may be made of transparent metal oxide, for example, indium tin oxide (ITO), indium zinc oxide (IZO), zinc oxide (ZnO), or indium tin zinc oxide (ITZO).

The light emitting element ED may include a first light emitting structure EU-1, a second light emitting structure EU-2 disposed on the first light emitting structure EU-1, and a third light emitting structure EU-3 disposed on the second light emitting structure EU-2. A charge generation layer CGL1 may be disposed between the first light emitting structure EU-1 and the second light emitting structure EU-2, and a charge generation layer CGL2 may be disposed between the second light emitting structure EU-2 and the third light emitting structure EU-3.

The first light emitting structure EU-1 may include a first hole transport region HTR-1, a first emission layer EML-1, and a first electron transport region ETR-1, and the second light emitting structure EU-2 may include a second hole transport region HTR-2, a second emission layer EML-2, and a second electron transport region ETR-2, and the third light emitting structure EU-3 may include a third hole transport region HTR-3, a third emission layer EML-3, and a third electron transport region ETR-3.

Each of the first, second, and third hole transport regions HTR-1, HTR-2, and HTR-3 may include at least one of a hole injection layer, a hole transport layer, an emission auxiliary layer, or an electron blocking layer. For example, each of the first, second, and third hole transport regions HTR-1, HTR-2, and HTR-3 may include a hole injection layer and a hole transport layer, which are sequentially laminated. In the light emitting element ED according to an embodiment, all the first, second, and third hole transport regions HTR-1, HTR-2, and HTR-3 may have the same structure and be made of the same material. However, embodiments are not limited thereto, and at least one of the first, second, and third hole transport regions HTR-1, HTR-2, and HTR-3 may have a laminated structure different from that of the rest, or include a hole transport material different from that of the rest.

In an embodiment, the first, second, and third light emitting structures EU-1, EU-2, and EU-3 of the light emitting element ED may emit light having different wavelength ranges, respectively. Thus, the light emitting element ED according to an embodiment may emit light that is a combination of light provided from the light emitting structure EU-1, EU-2, and EU-3. For example, in the display device DD (see FIG. 5) according to an embodiment, the first, second, and third light emitting elements ED1, ED2, and ED3 may emit light having the same wavelength range, and the light may be filtered and emitted as light having a wavelength range corresponding to each of the emission area PXA-B, PXA-G, and PXA-R by the light control panel OP (see FIG. 5).

Each of the first, second, and third functional layers FL1, FL2, and FL3 (see FIG. 5) may include first, second, and third emission layers EML-1, EML-2, and EML-3 including different luminescent materials. Each of the first, second, and third emission layers EML-1, EML-2, and EML-3 may emit light having different wavelength ranges. Each of the first, second, and third emission layers EML-1, EML-2, and EML-3 may further include an auxiliary emission layer that improves the light emitting efficiency in addition to a main emission layer including a luminescent material that emits light having a selected color. In an embodiment, each of the first, second, and third emission layers EML-1, EML-2, and EML-3 may have a structure in which sub emission layers having different luminescent material compositions are laminated. In the light emitting element ED according to an embodiment, the first, second, and third emission layers EML-1, EML-2, and EML-3 may have the same structure and be made of the same material. However, embodiments are not limited thereto, and at least one of the first, second, and third emission layers EML-1, EML-2, and EML-3 may have a laminated structure different from that of the rest, or include a luminescent material different from that of the rest. For example, each of the first, second, and third emission layers EML-1, EML-2, and EML-3 may include laminated sub emission layers or auxiliary emission layers.

Each of the first, second, and third electron transport regions ETR-1, ETR-2, and ETR-3 may include at least one of a hole blocking layer, an electron transport layer, or an electron injection layer. For example, each of the first, second, and third electron transport regions ETR-1, ETR-2, and ETR-3 may include an electron transport layer and an electron injection layer. For example, in the light emitting element ED according to an embodiment, all the first, second, and third electron transport regions ETR-1, ETR-2, and ETR-3 may have the same structure and be made of the same material. However, embodiments are not limited thereto, and at least one of the first, second, and third electron transport regions ETR-1, ETR-2, and ETR-3 may have a laminated structure different from that of the rest, or include an electron transport material different from that of the rest.

The light emitting element ED according to an embodiment may include charge generation layers CGL1 and CGL2. In case that a voltage is applied to the light emitting element ED, the charge generation layers CGL1 and CGL2 may generate charges (e.g., electrons and holes) by forming a complex through an oxidation-reduction reaction. The charge generation layers CGL1 and CGL2 may provide the generated charges to each of the adjacent light emitting structures EU-1, EU-2, and EU-3. The charge generation layers CGL1 and CGL2 may improve efficiency of current generated in each of the adjacent light emitting structures EU-1, EU-2, and EU-3 and serve to adjust a balance of the charges between the adjacent light emitting structures EU-1 and EU-3).

Each of the charge generation layers CGL1 and CGL2 may have a layered structure in which an n-type charge generation layer n-CGL and a p-type charge generation layer p-CGL are bonded to each other.

The n-type charge generation layer n-CGL may be a charge generation layer that provides electrons to the adjacent light emitting structures EU-1, EU-2, and EU-3. The n-type charge generation layer n-CGL may be a layer in which a base substrate is doped with an n-dopant. The p-type charge generation layer p-CGL may be a charge generation layer that provides holes to the adjacent light emitting structures EU-1, EU-2, and EU-3. The p-type charge generation layer p-CGL may be a layer in which a base substrate is doped with a p-dopant.

FIG. 7 is a schematic cross-sectional view illustrating a portion of the display panel according to an embodiment. FIG. 7 is an enlarged schematic cross-sectional view of an area WW' of FIG. 5. FIG. 7 is a schematic cross-sectional view illustrating the first retarder RT and the inorganic capping layer CP in more detail according to an embodiment. Contents duplicated with those described in FIG. 5 with respect to the first retarder RT and the inorganic capping layer CP will not be described again, and differences will be explained.

The first retarder RT may change a polarization state of light incident into the first retarder RT. The first retarder RT may include a $\lambda/4$ phase difference retarder. The first retarder RT may be an optical layer that delays a phase of provided light by $\lambda/4$. The in-plane phase difference value of the first retarder RT for light having a wavelength of about 550 nm may be about 100 nm or more and about 500 nm or less. Young's modulus of the first retarder RT may be about 0.1 GPa or more and about 3 GPa or less. A first thickness d1 of the first retarder RT may be about 0.5 $\mu$m or more and about 2.5 $\mu$m or less. For example, the first thickness d1 of the first retarder RT may be about 0.7 $\mu$m or more and about 1.5 $\mu$m or less.

The first retarder RT may be a liquid crystal coating type. The first retarder RT may include a base layer and a liquid crystal layer oriented on a surface of the base layer. However, embodiments are not limited thereto, and the first retarder RT may be provided as only a liquid crystal layer without the base layer as a support. The liquid crystal layer may include a reactive liquid crystal monomer (e.g., calamitic mesogen that exhibits a nematic liquid crystalline phase). The liquid crystal layer may be manufactured through a process of applying and aligning a reactive liquid crystal monomer and then polymerizing and curing the reactive liquid crystal monomer. A curing degree of the liquid crystal layer may be about 70% or more and about 90% or less. In an embodiment, the liquid crystal layer may include a photoreactive polymer having refractive index anisotropy.

The inorganic capping layer CP may cover the first retarder RT. The inorganic capping layer CP may include a first inorganic layer CP1 disposed on the first retarder and a second inorganic layer CP2 disposed on the first inorganic layer CP1. The first inorganic layer CP1 may be disposed (e.g., directly disposed) on the first retarder RT, and the second inorganic layer CP2 may be disposed (e.g., directly disposed) on the first inorganic layer CP1.

A second thickness d2 of the first inorganic layer CP1 may be substantially the same as a third thickness d3 of the second inorganic layer CP2, or the second thickness d2 of the first inorganic layer CP1 may be greater than the third thickness d3 of the second inorganic layer CP2. In the description, the term "substantially the same" may include not only a case in which the thicknesses of the components are physically completely the same, but also a case in which there is a difference by an error range that occurs during the process in spite of the same design. The second thickness d2 of the first inorganic layer CP1 may be about 0.1 $\mu$m or more and about 0.8 $\mu$m or less. For example, the second thickness d2 of the first inorganic layer CP1 may be about 0.2 $\mu$m or more and about 0.4 $\mu$m or less. The third thickness d3 of the second inorganic layer CP2 may be about 0.1 μm or more and about 0.5 μm or less. For example, the third thickness d3 of the second inorganic layer CP2 may be about 0.1 μm or more and about 0.4 μm or less. The sum of the second thickness d2 of the first inorganic layer CP1 and the third thickness d3 of the second inorganic layer CP2 may be less than the first thickness d1 of the above-described first retarder RT.

The first inorganic layer CP1 may include silicon nitride, and the second inorganic layer CP2 may include silicon nitrogen oxide. A first ratio of oxygen atoms included in the first inorganic layer CP1 may be less than a second ratio of oxygen atoms included in the second inorganic layer CP2. For example, the first inorganic layer CP1 may not include oxygen atoms, and thus, the first ratio may be substantially 0.

A refractive index of the first inorganic layer CP1 may be greater than a refractive index of the second inorganic layer CP2. The refractive index of the first inorganic layer CP1 may be greater than about 1.7 and less than or equal to about 2.0 with respect to light having a wavelength of about 550 nm. For example, the refractive index of the first inorganic layer CP1 may be about 1.80 or more and about 1.90 or less with respect to light having a wavelength of about 550 nm, but embodiments are not limited thereto. The refractive index of the second inorganic layer CP2 may be about 1.5 or more and about 1.7 or less with respect to light having a wavelength of about 550 nm. For example, the refractive index of the second inorganic layer CP2 may be about 1.55 or more and about 1.65 or less with respect to light having a wavelength of about 550 nm.

Residual stress of the first inorganic layer CP1 may be greater than residual stress of the second inorganic layer CP2. A liquid crystal layer of the first retarder RT may be formed through a curing process, and the residual stress of the first inorganic layer CP1 applied according to the curing process may be greater than residual stress of the second inorganic layer CP2. For example, compressive stress of the first inorganic layer CP1 may be greater than compressive stress of the second inorganic layer CP2. In another example, the compressive stress of the first inorganic layer CP1 may be greater than tensile stress of the second inorganic layer CP2.

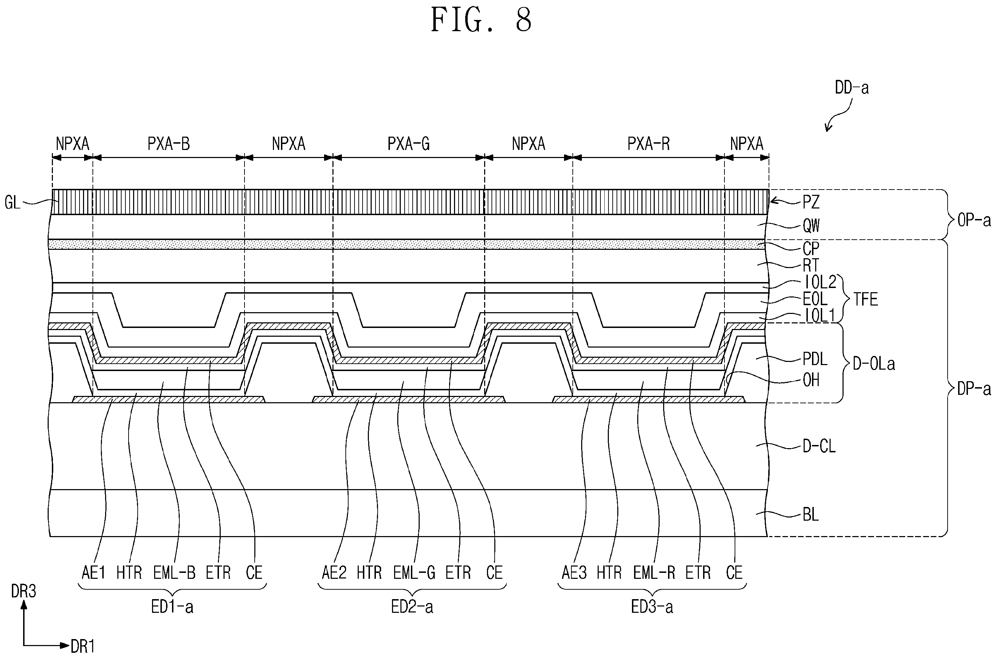

FIG. 8 is a schematic cross-sectional view of a display device according to another embodiment. FIG. 8 is a schematic cross-sectional view of a display device corresponding to that of FIG. 5. In descriptions of components of a display device DD-a according to an embodiment, contents duplicated with those described in FIG. 5 will not be described again, and differences will be explained.

Referring to FIG. 8, the display device DD-a may include a display panel DP-a and a light control panel OP-a disposed on the display panel DP-a.

The light control panel OP-a may include a second retarder QW and a polarizing layer PZ. The light control panel OP-a may not include a color filter layer CFL (see FIG. 5).

The display panel DP-a may include a display element layer D-OLa, and the display element layer D-OLa may include a first light emitting element ED1-a, a second light emitting element ED2-a, and a third light emitting element ED3-a. The first light emitting element ED1-1 may emit blue light, the second light emitting element ED2-a may emit green light, and the third light emitting element ED3-a may emit red light.

The first light emitting element ED1-a may include a first pixel electrode AE1, a hole transport region HTR, an emission layer EML-B, an electron transport region ETR, and a second electrode CE, the second light emitting element ED2-a may include a second pixel electrode AE2, a hole transport region HTR, an emission layer EML-G, an electron transport region ETR, and a second electrode CE, and the third light emitting element ED3-a may include a third pixel electrode AE3, a hole transport region HTR, an emission layer EML-R, an electron transport region ETR, and a second electrode CE.

In FIG. 8, the emission layers EML-R, EML-G, and EML-B of the light emitting elements ED1-a, ED2-a, and ED3-a may be disposed within a light emitting opening (or opening) OH defined in a pixel defining layer PDL, and an embodiment in which the hole transport region HTR, the electron transport region ETR, and the second electrode EL2 are provided as common layers throughout the light emitting elements ED1-a, ED2-a, and ED3-a is illustrated. However, embodiments are not limited thereto, and unlike that illustrated in FIG. 8, in an embodiment, the hole transport region HTR and the electron transport region ETR may be provided to be patterned inside the light emitting opening OH defined in the pixel defining layer PDL. For example, in an embodiment, the hole transport region HTR, the emission layer EML-R, EML-G, and EML-B, and the electron transport region ETR of the light emitting elements ED1-a, ED2-a, and ED3-a may be provided to be patterned using an inkjet printing method.

Hereinafter, characteristics evaluation results of the display panel and display device according to an embodiment will be described with reference to embodiments, comparative examples, and the above-described FIG. 7. For example, embodiments shown below may be examples for helping understanding of the invention, and the scope of the invention is not limited thereto.

(Manufacture of Display device)

The display devices according to Embodiments and Comparative Examples were manufactured by forming a first retarder having a thickness of about 1.2 μm on a glass substrate and forming an inorganic capping layer on the first retarder.

In Embodiments 1 and 2, the inorganic capping layer was manufactured to include a first inorganic layer and a second inorganic layer disposed on the first inorganic layer, and in Comparative Example 1, the inorganic capping layer was manufactured to include only the first inorganic layer. Thicknesses of the first and second inorganic layers, materials contained in the first and second inorganic layers, and refractive indexes of the first and second inorganic layers according to Embodiments 1 and 2 were shown in Table 1 below. For example, a thickness of the first inorganic layer, a material contained in the first inorganic layer, and a refractive index of the first inorganic layer according to Comparative Example 1 are shown in Table 1 below. In Embodiments 1 and 2, and Comparative Example 1, the display devices having the same structure as illustrated in FIG. 4, except for differences in laminated structure within the inorganic capping layer were manufactured.

In manufacturing according to Embodiments and Comparative Examples, a first material was silicon nitride, a second material was silicon nitride, and a refractive index of each layer was measured with respect to light having a wavelength of about 550 nm.

[Table 1]

| | First inorganic layer (CP1) | | | Second inorganic layer (CP2) | | |
|---|---|---|---|---|---|---|
| | Second thickness (d2, $\mu$m) | Material | Refractive index | Third thickness (d3, $\mu$m) | Material | Refractive index |
| Embodiment 1 | 0.3 | First material | 1.84 | 0.1 | Second material | 1.61 |
| Embodiment 2 | 0.3 | First material | 1.84 | 0.3 | Second material | 1.61 |
| Comparative Example 1 | 0.3 | First material | 1.84 | - | | |

(Evaluation of Display device)

Residual stress $\sigma_{0h}$ and $\sigma_{168h}$ of each of the first and second inorganic layers according to Embodiments 1 and 2 described above were measured, and residual stress $\sigma_0$ and $\sigma_{168h}$ of the first inorganic layer according to Comparative Example 1 were measured. The first retarder may be manufactured through a curing process, and the residual stress $\sigma_0$ may refer to compressive stress or tensile stress applied to each of the first and second inorganic layers due to the curing process. The residual stress $\sigma_{168h}$ may refer to compressive stress or tensile stress of each of the first and second inorganic layers after being exposed for about 168 hours at a temperature of about 85°C and an absolute humidity of about 85% according to Embodiments and Comparative Examples. The total residual stress $\sigma_{total}$ and $\sigma_{168h}$ of the inorganic capping layer was calculated by adding the measured residual stresses $\sigma_{168h}$ of each of the first and second inorganic layers. For this, a film corresponding to a 6-inch Si wafer was deposited and the stress was calculated afterwards by measuring the degree of deformation of the wafer with a TENCOR FLX 2350 instrument. The results of the above measurements and calculations are shown in Table 2 below.

[Table 2]

| | First inorganic layer (CP1) | | Second inorganic layer (CP2) | | Inorganic capping layer (CP) |
|---|---|---|---|---|---|
| | $\sigma_{0h}$(MPa) | $\sigma_{168h}$(MPa) | $\sigma_{0h}$(MPa) | $\sigma_{168h}$(MPa) | $\sigma_{total,168h}$(MPa) |
| Embodiment 1 | -240 | -231 | -14 | +40 | -191 |
| Embodiment 2 | -240 | -231 | -14 | +40 | -191 |
| Comparative Example 1 | -240 | -231 | - | | -231 |

Optical properties of the first retarder RT included in each of the above-described Embodiments 1 and 2, and Comparative Example 1 were evaluated. For example, a laminated structure of the first retarder RT and the inorganic capping layer CP according to Embodiments and Comparative Examples were randomly arranged between orthogonal polarizing plates to obtain secondary efficiency $T_{0h}$ and $T_{500h}$ and tertiary efficiency $D_{0h}$ and $D_{500h}$ were measured. The secondary efficiency $T_{0h}$ was measured using Equation 1 below, and the tertiary efficiency $D_{0h}$ was measured using

Equation 2 below. The secondary efficiency $T_{500h}$ and the tertiary efficiency $D_{500h}$ may correspond to values measured after exposed for about 500 hours at a temperature of about 85°C and an absolute humidity of about 85% according to Embodiments and Comparative Examples The secondary efficiency $T_{0h}$ was measured under the condition in which $\Phi$ is 45° in Equation 1 below.

[Equation 1]

$$T_{0h} = sin^2 (\frac{\pi \Delta nd}{\lambda}) sin^2 (2\Phi)$$

In Equation 1, $\Phi$ is an angle angled between an optical axis of the first retarder and an optical axis of the polarizing plate, n is a birefringence of the first retarder, and d is a thickness of the first retarder. In other words, the given equation describes the transmission coefficient for a certain polarization state of light passing through a birefringent material or optical retarder. The term $\Delta n$ represents birefringence, which is the difference between the refractive indices of the extraordinary and ordinary axes in an anisotropic material. The term d refers to the thickness of the birefringent layer, while $\lambda$ is the wavelength of the incident light. The angle $\pi$ represents the polarization angle of the incident light relative to the optical axis of the birefringent material. The first part of the equation, which includes the sine squared function with the term $\pi$ times $\Delta n$ times d divided by $\lambda$, describes the phase retardation caused by the birefringent material. This phase shift depends on the thickness of the layer, the birefringence, and the wavelength of the light. The second sine squared term, which depends on twice the angle $\Phi$, accounts for the input polarization angle relative to the fast and slow axes of the birefringent material. When $\Phi$ is zero or ninety degrees, the term becomes zero, meaning no transmission occurs. When $\Phi$ is forty-five degrees, the term reaches its maximum value, leading to the strongest transmission effect. This equation describes how a birefringent material modifies the polarization state of transmitted light, with the transmission depending on the birefringence, thickness, and wavelength. It is commonly used in optical retarders, liquid crystal displays, and wave plates to control light polarization.

[Equation 2]

$$D_{0h} = \frac{T_{max}}{T_{min} + T_{max}}$$

In Equation 2, $T_{max}$ refers to the maximum value of $T_{0h}$ according to $\Phi$ in Equation 1, and $T_{min}$ refers to the minimum value of $T_{0h}$ according to $\Phi$ in Equation 1.

Transmittance and reflectance RSCI and RSCE of each of Embodiment 1, Embodiment 2, and Comparative Example 1 described above were measured. The transmittance was measured using a CA-310 from Konica Minolta for visible light having a wavelength range of about 380 nm to about 780 nm, and reflectance RSCI and RSCE were measured using a CM-3700A from Konica Minolta. The reflectance RSCI means specular component included (SCI) reflectance, and reflectance (RSCE) means specular component excluded (SCE) reflectance. The results of the above measurements and calculations are shown in Table 3 below. The CA-310 from Konica Minolta is used to measure optical properties relevant to birefringent materials, retarders, and liquid crystal layers. It analyzes phase difference by detecting luminance and chromaticity variations, providing insights into optical transmission and efficiency. Residual stress in inorganic layers can affect polarization and brightness, which the CA-310 identifies through color shifts and display uniformity measurements. The device also helps assess the impact of refractive index variations on light refraction and transmission, ensuring color accuracy. Additionally, it can verify curing effects in liquid crystal layers by detecting luminance stability and alignment consistency, making it an essential tool for evaluating display performance and optical layer quality. The CM-3700A from Konica Minolta is a high-precision spectrophotometer capable of measuring several key optical properties, including refractive index variations, phase difference, and transmission efficiency in birefringent materials, retarders, and liquid crystal layers. It can detect spectral reflectance and transmittance changes, which are influenced by phase retardation effects and material stress. The refractive index of thin films and coatings can be indirectly analyzed by examining spectral shifts and transmittance variations over a range of wavelengths. The phase difference, as described by the equation involving birefringence and thickness, influences light polarization and can be assessed by analyzing spectral transmission at different polarization states. Additionally, curing effects in liquid crystal layers can be evaluated by measuring spectral stability and uniformity before and after the curing process. The CM-3700A provides high-accuracy data for optical materials, making it a useful tool for evaluating the properties that affect display performance and optical layer functionality.

[Table 3]

| | Secondary efficiency | | Tertiary efficiency | | Transmittance (%) | Reflectance | |
|---|---|---|---|---|---|---|---|
| | $T_{0h}$ (%) | $T_{500h}$ (%) | $D_{0h}$ (%) | $D_{500h}$ (%) | Transmittance (%) | $R_{SCI}$ (%) | $R_{SCE}$ (%) |
| Embodiment 1 | 47.3 | 46.0 | 99.74 | 99.76 | 99.7 | 7.2 | 0.42 |
| Embodiment 2 | 46.4 | 45.1 | 99.76 | 99.74 | 97.1 | 10.1 | 0.48 |
| Comparative Example 1 | 46.1 | 25.6 | 99.75 | 86.86 | 95.9 | 11.3 | 0.52 |

Referring to Tables 1 to 3, in the display device according to an embodiment, as compared to the display device according to Comparative Example, since the inorganic capping layer covering the first retarder not only includes the first inorganic layer, but also includes the second inorganic layer, it is seen that reliability is improved with relatively high transmittance and low reflectance. For example, the display device according to an embodiment may include a second inorganic layer of which a ratio of oxygen atoms is relatively high compared to that of the first inorganic layer to improve device reliability.

Referring to Table 2, it is seen that the overall residual stress $\sigma_{total}$ and $_{168h}$ of the inorganic capping layer in Comparative Example 1 is relatively large compared to that according to Embodiments. As compared to Embodiments, Comparative Example 1, since the second inorganic layer including the second material of silicon nitrogen oxide is not provided, it is understood that a size of the total residual stress $\sigma_{total}$ and $_{168h}$ in the inorganic capping layer is relatively large. On the other hand, in the case of Embodiments, as the second inorganic layer including the second material of silicon nitrogen oxide is provided, even if the first retarder is manufactured through the curing process, since the residual stress of the compressive stress and the tensile stress under high-temperature and high-humidity environments is low, the reliability of the display panel may be improved.

Referring to Table 3, in Comparative Example 1, as compared to Embodiments, it is seen that the secondary efficiency $T_{500h}$ is significantly reduced compared to the secondary efficiency $T_{0h}$, and the tertiary efficiency $D_{500h}$ is significantly reduced compared to the tertiary efficiency $D_{0h}$. In Comparative Example 1, as compared to Embodiments, since the second inorganic layer is not provided, since phase delay function performance of the first retarder is reduced under the high-temperature and high-humidity environments, or a thickness of the first retarder is reduced, it is regarded that the secondary efficiency $T_{500h}$ is deteriorated. In Comparative Example 1, as compared to Embodiments, since the second inorganic layer is not provided, it is regarded that an orientation of the first retarder is distorted under the high-temperature and high-humidity environments, it is regarded that the tertiary efficiency $D_{500h}$ is deteriorated. In Comparative Example 1, as compared to Embodiments, it is seen that transmittance of visible light within the device is reduced to increase in reflectance. In Comparative Example 1, as compared to Embodiments, as the second inorganic layer is not provided, since the reliability of the inorganic capping layer covering the first retarder is deteriorated, and the above-described secondary and tertiary efficiency are deteriorated, it is regarded that luminous efficiency according to Comparative Example 1 is substantially deteriorated.

Whether wrinkles occur on the first retarder according to Embodiment 1, Embodiment 2, and Comparative Example 1 described above was evaluated. For example, whether wrinkles occur on the first retarder according to Comparative Example 2 was evaluated. As compared to the above-described Embodiment 2, Comparative Example 2 are the same as Embodiments except that 'the first inorganic layer includes the second material, and the second inorganic layer includes the first material. The evaluation of whether the wrinkles occur was evaluated in a manner, in which O is marked in case that the wrinkles occur after being exposed for about 500 hours at a temperature of about 85°C and an absolute humidity of about 85%, but in case that the wrinkles do not occur, X is marked.

[Table 4]

| | Embodiment 1 | Embodiment 2 | Comparative Example 1 | Comparative Example 2 |
|---|---|---|---|---|
| Whether wrinkles occur | X | X | ○ | ○ |

Referring to Table 4, in the display device according to an embodiment, as compared to the display devices according to Comparative Examples, since the inorganic capping layer covering the first retarder includes the second inorganic layer, and a ratio of oxygen atoms contained in the second inorganic layer is relatively high compared to that of the first inorganic layer, it is confirmed that surface flatness and reliability are improved.

In Comparative Example 1, as compared to Embodiments, as the second inorganic layer is not provided, since the wrinkles occurs on a surface of the first retarder, it is regarded that the surface flatness and reliability are deteriorated. In Comparative Example 2, as the second inorganic layer is provided, but the second material is not provided, and the first material having the relatively low oxygen atom ratio is provided, since the wrinkles occur on a surface of the first retarder, it is regarded that the surface flatness and reliability are deteriorated.

The display panel according to the embodiment may include the first inorganic layer and the second inorganic layer to improve the quality of the first retarder, thereby realizing the excellent emission characteristics. For example, the display device according to the embodiment may include the display panel according to the embodiment to improve the reliability.

It will be apparent to those skilled in the art that various modifications and variations can be made in the inventive concept. Thus, it is intended that the disclosure covers the modifications and variations of this invention provided they come within the scope of the appended claims and their equivalents.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

**Claims**

1. A display device (DD) comprising:

   a display panel (DP); and
   a window disposed on the display panel (DP), wherein
   the display panel (DP) comprises:

      a circuit element layer (D-CL);
      a display element layer (D-OL) disposed on the circuit element layer (D-CL) and comprising a light emitting element;
      an encapsulation layer (TFE) disposed on the display element layer (D-OL);
      a first retarder (RT) disposed on the encapsulation layer (TFE);
      a first inorganic layer (CP1) disposed on the first retarder (RT); and
      a second inorganic layer (CP2) disposed on the first inorganic layer (CP1), and

   a ratio of oxygen atoms contained in the first inorganic layer (CP1) is less than that of oxygen atoms contained in the second inorganic layer (CP2).

2. The display device (DD) of claim 1, wherein a refractive index of the first inorganic layer (CP1) is greater than that of the second inorganic layer (CP2).

3. The display device (DD) of claim 1 or 2, wherein

   the first inorganic layer (CP1) comprises silicon nitride, and/or
   the second inorganic layer (CP2) comprises silicon nitrogen oxide.

4. The display device (DD) of any one of claims 1 to 3, wherein residual stress of the first inorganic layer (CP1) is greater than that of the second inorganic layer (CP2).

5. The display device (DD) of any one of claims 1 to 4, wherein a first thickness (d1) of the first retarder (RT) is greater than a sum of a second thickness (d2) of the first inorganic layer (CP1) and a third thickness (d3) of the second inorganic layer (CP2).

6. The display device (DD) of claim 5, wherein the first thickness (d1) is in a range of about 0.5 to about 2.5 $\mu$m,

   the second thickness (d2) is in a range of about 0.1 $\mu$m to about 0.8 $\mu$m, and/or
   the third thickness (d3) is in a range of about 0.1 $\mu$m to about 0.5 $\mu$m.

7. The display device (DD) of claim 5 or 6, wherein the second thickness (d2) is equal to or greater than the third thickness (d3).

8. The display device (DD) of any one of claims 1 to 7, wherein the first retarder (RT) comprises a liquid crystal layer, and the liquid crystal layer has a curing degree of about 70% or more and about 90% or less.

9. The display device (DD) of any one of claims 1 to 8, wherein the first retarder (RT) has a phase difference of about 100 nm or more and about 500 nm or less in a wavelength of about 550 nm.

10. The display device (DD) of any one of claims 1 to 9, wherein the encapsulation layer (TFE) comprises:

a first encapsulation inorganic layer (IOL1) disposed on the display element layer (D-OL),
an encapsulation organic layer (EOL) disposed on the first encapsulation inorganic layer (IOL1),
a second encapsulation inorganic layer (IOL2) disposed on the encapsulation organic layer (EOL), and wherein the first retarder (RT) is directly disposed on the second encapsulation inorganic layer (IOL2).

11. The display device (DD) of any one of claims 1 to 10, further comprising:

an optical layer disposed between the display panel (DP) and the window, wherein
the optical layer comprises:

a second retarder (QW) disposed on the second inorganic layer (CP2); and
a polarizing layer (PZ) disposed on the second retarder (QW).

12. The display device (DD) of claim 11, wherein the optical layer further comprises a color filter layer (CFL) disposed between the second inorganic layer (CP2) and the second retarder (QW).

13. The display device (DD) of claim 11 or 12, wherein the polarizing layer (PZ) comprises a wire grid polarizing plate.

14. The display device (DD) of any one of claims 11 or 13, wherein the second retarder (QW) comprises a $\lambda/4$ phase difference retarder.

15. An electronic device comprising:

a display device (DD) including a display panel (DP) and a window disposed on the display panel (DP), wherein the display panel (DP) comprises:

a circuit element layer (D-CL);
a display element layer (D-OL) disposed on the circuit element layer (D-CL) and comprising a light emitting element;
an encapsulation layer (TFE) disposed on the display element layer (D-OL);
a first retarder (RT) disposed on the encapsulation layer (TFE);
a first inorganic layer (CP1) disposed on the first retarder (RT); and
a second inorganic layer (CP2) disposed on the first inorganic layer (CP1), and

a ratio of oxygen atoms contained in the first inorganic layer (CP1) is less than that of oxygen atoms contained in the second inorganic layer (CP2).

# FIG. 1A

# FIG. 1B

# FIG. 2A

# FIG. 2B

DD DA NDA NDA DD DA HS-2 ] HS HS-1

PP

OL_L OL_R OL

DR2
DR1
DR3

# FIG. 3

DD

PX

DA

NDA

BL

GDC

SGL

DL  CSL  GL  PL

PLD  D-PD

DR2
DR1
DR3

# FIG. 4

FIG. 5

# FIG. 6

ED

CE
ETR-3 ⎫
EML-3 ⎬ EU-3
HTR-3 ⎭
p-CGL ⎫
n-CGL ⎬ CGL2
ETR-2 ⎫
EML-2 ⎬ EU-2
HTR-2 ⎭
p-CGL ⎫
n-CGL ⎬ CGL1
ETR-1 ⎫
EML-1 ⎬ EU-1
HTR-1 ⎭
AE

FL

DR3

# FIG. 7

FIG. 8

Europäisches
Patentamt

European
Patent Office

Office européen
des brevets

# EUROPEAN SEARCH REPORT

**Application Number**

EP 25 17 0988

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/006172 A1 (LEE KYUNGHEE [KR] ET AL) 5 January 2023 (2023-01-05) | 1-5,7, 9-12,14, 15 | INV. H10K59/80 |
| Y | * figures 1,4 * <br> * paragraph [0054] * <br> * paragraph [0059] * <br> * paragraph [0061] * <br> * paragraph [0073] * <br> * paragraph [0082] * <br> * paragraph [0093] * <br> * paragraph [0096] - paragraph [0097] * <br> * paragraph [0102] * <br> * paragraph [0117] * <br> ----- | 8 | |
| X | US 2017/317287 A1 (HIRAKATA JUNICHI [JP] ET AL) 2 November 2017 (2017-11-02) <br> * figure 3B * <br> * paragraph [0061] * <br> * paragraph [0079] * <br> * paragraph [0085] - paragraph [0086] * <br> * paragraph [0091] - paragraph [0092] * <br> * paragraph [0100] * <br> * paragraph [0120] * <br> * paragraph [0126] * <br> * paragraph [0142] * <br> ----- | 1-6,12, 13 | **TECHNICAL FIELDS SEARCHED (IPC)** <br><br> H10K |
| Y | EP 1 795 575 B1 (MERCK PATENT GMBH [DE]) 11 March 2009 (2009-03-11) <br> * paragraph [0098] * <br> ----- | 8 | |

The present search report has been drawn up for all claims

| Place of search | Date of completion of the search | Examiner |
|---|---|---|
| The Hague | 2 September 2025 | Baum, Thomas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 0988

This annex lists the patent family members relating to the patent documents cited in the above-mentioned European search report.
The members are as contained in the European Patent Office EDP file on
The European Patent Office is in no way liable for these particulars which are merely given for the purpose of information.

02-09-2025

| Patent document cited in search report | Publication date | Patent family member(s) | | Publication date |
|---|---|---|---|---|
| US 2023006172 A1 | 05-01-2023 | CN | 115497989 A | 20-12-2022 |
| | | KR | 20220169518 A | 28-12-2022 |
| | | US | 2023006172 A1 | 05-01-2023 |
| US 2017317287 A1 | 02-11-2017 | CN | 107408359 A | 28-11-2017 |
| | | JP | 6612787 B2 | 27-11-2019 |
| | | JP | WO2016125801 A1 | 24-11-2017 |
| | | KR | 20170098884 A | 30-08-2017 |
| | | US | 2017317287 A1 | 02-11-2017 |
| | | WO | 2016125801 A1 | 11-08-2016 |
| EP 1795575 B1 | 11-03-2009 | NONE | | |

For more details about this annex : see Official Journal of the European Patent Office, No. 12/82